# EUROPEAN PATENT APPLICATION

(11) **EP 4 675 005 A1**
(43) Date of publication of application: **07.01.2026**
(21) Application number: 25187384.0
(22) Date of filing: 03.07.2025
(51) Int. Cl.: C23C 16/32, C23C 16/44, C23C 16/455, C23C 16/458, C23C 16/46, C23C 16/54, C30B 25/08, C30B 25/10, C30B 25/12, C30B 25/14, F27B 17/00, F27D 3/12, F27D 5/00, H01L 21/67, H01L 21/677, H01L 21/687

(54) **REACTION CHAMBER ASSEMBLY**

(30) Priority: 05.07.2024 IT 202400015523
(71) Applicant: LPE S.p.A., 20021 Baranzate (MI) (IT)
(72) Inventor: MESCHIA, Maurilio, I-20021 BARANZATE, MILANO (IT)
(74) Representative: Di Biase, Fabio

(57) **Abstract**

A reaction chamber assembly for a reactor for the epitaxial deposition of a semiconductor film on at least two substrates, comprising: (a) an enclosure, (b) at least two casings contained within said enclosure, (c) at least two deposition units, and (d) an insulating system. Each casing contains at least one deposition unit. Each deposition unit is provided with at least one receiving area adapted to receive a substrate holder and suitable for the epitaxial deposition of a semiconductor film on a substrate. The insulating system comprises an intermediate insulating element positioned between the at least two casings.

## Description

### FIELD OF INVENTION

The present invention relates to the field of reactors for the epitaxial growth of films on a substrate.

### BACKGROUND OF THE DISCLOSURE

Semiconductor films made by epitaxial growth, also known as epilayers, are formed by deposition in the reaction chamber of a reactor. The deposited material may be the same as the substrate or involve different semiconductors with specific desirable qualities. Epitaxial techniques allow to control the crystal structure formed over the substrate and to improve the epilayer surface features, making them suitable for the manufacturing of highly complex microprocessors and memory devices.

Typically, the reaction chamber is heated to a desired temperature before film deposition, and then the temperature is maintained substantially constant throughout the deposition process. To this effect, insulating systems are used to reduce the energy required to achieve and maintain the nominal temperature of the deposition process.

The epitaxial growth equipment for the SiC industry usually comprises a reactor containing a reaction and deposition chamber where the deposition process occurs.

The reaction and deposition chambers are often equipped with one deposition area, i.e., the space where the epitaxial reaction and deposition takes place (herein after referred to as "deposition unit"). This area can be configured either for epitaxial deposition on a single substrate, or for the simultaneous deposition on a plurality of substrates. The deposition process is accordingly defined as a single-wafer or batch process respectively.

In single wafer processes, such as the one described in WO2004053187A1, the deposition conditions can be accurately controlled, also thanks to the relatively small dimensions of the deposition area, and the quality of the resulting deposition can be exceptionally good. However., the throughput is inherently limited by the single-wafer approach.

Conversely, batch processes allow an improved throughput compared to their single-wafer counterparts, but they are detrimental to film quality, as the temperature and the rotation speeds of multiple substrates cannot be accurately independently controlled. This is also due to the increased size of the deposition area, since the latter needs to simultaneously accommodate a plurality of substrates.

Alternatively, some reactors are equipped with a plurality of reaction chambers, with each chamber hosting one deposition area. These designs increase throughput at the expense of their footprint on the manufacturing floor. These encumbering solutions thus cause an increase in cost of ownership.

Additionally, during the epitaxial deposition process, the deposition area can be subject to parasitic deposition. This undesired phenomenon is particularly impactful in case of silicon carbide epitaxy because of the superior hardness of the material, which makes it very difficult to remove, especially compared to Si or other common Si-based compounds. This results in frequent maintenance and replacement of parts, affecting throughput in both single wafer and batch-type processes, since the reactor must be stopped for maintenance operations and the reaction chamber is exposed to air in the process.

It is therefore desirable to provide a reaction chamber assembly designed to process at least two substrates at a time in separate deposition areas, without compromising deposition quality and with a compact design.

It is furthermore desirable to provide a reaction chamber assembly wherein each deposition area is removable in one piece for easy preventive maintenance operations on the same.

It is furthermore desirable to provide a reactor adapted to impart different heating to different deposition units.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention assembly to provide a reaction chamber assembly and a reactor for the epitaxial deposition of semiconductor films on a substrate overcoming the downsides of the prior art.

Specifically, it is an object of the invention to provide a reaction chamber assembly adapted to process at least two substrates at a time in separate deposition units, without compromising deposition quality and exhibiting a compact design.

It is another object of the invention to provide a reaction chamber assembly wherein each deposition unit is removable in one piece for easy preventive maintenance operations.

It is another object of the invention to provide a reactor adapted to impart different heating to different deposition units.

The main objectives hereinbefore described are achieved through the invention recited in the appended claims, which constitute an integral part of the present description.

It is noted that the use of reference signs in the claims does not limit their scope. The sole purpose of reference signs is to make the claims easier to understand.

### BRIEF DESCRIPTION OF THE DRAWING FIGURES

The illustrations presented herein are not meant to be actual views of any particular material, structure, or device, but are merely idealized representations that are used to describe embodiments of the disclosure.
Fig. 1 is an orthographic three-dimensional view of a reaction chamber assembly according to an embodiment of the invention.
Fig. 2 is a plan view of a reactor section in the transverse plane (yz), according to an embodiment of the invention.
Fig. 3 is a plan view of a reactor section in the transverse plane (yz), according to an embodiment of the invention.
Fig. 4 is an orthographic three-dimensional view of a deposition unit according to the invention.
Fig. 5 is an orthographic three-dimensional view of a deposition unit according to the invention.
Fig. 6 is an orthographic three-dimensional view of a section of the reactor in the longitudinal direction, according to an embodiment of the invention.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

It will be appreciated that elements in the figures are illustrated for simplicity and clarity. In particular some elements may have been omitted or may have not necessarily been drawn to scale. For example, the dimensions of some of the elements in the figures may be exaggerated relative to other elements to help improve understanding of illustrated embodiments of the present disclosure.

According to a first aspect, the invention relates to a reaction chamber assembly **1** for a reactor **2** for the epitaxial deposition of a semiconductor film on at least two substrates.

The reaction chamber assembly **1** comprises an enclosure **3** and at least two casings **4** contained within said enclosure.

The reaction chamber assembly **1** further comprises at least two deposition units **5;** and an insulating system.

Specifically, the at least two deposition units **5** are arranged in such a way that each casing **4** contains at least one deposition unit **5.**

Each deposition unit **5** is provided with at least one receiving area **6** adapted to receive a substrate holder **7** and is suitable for the epitaxial deposition of a semiconductor film on a substrate.

The insulating system comprises an intermediate insulating element **11** positioned between the at least two casings **4.**

Therefore, at least **two** casings are positioned facing each other, and at least the intermediate insulating element **11** is positioned between them.

Advantageously, the intermediate insulating element **11** may allow to thermally decouple the at least two casings **4** from each other.

For example, the insulating element **11** can be made of porous carbonaceous materials.

For instance, carbon composites made from short cut carbon fibers, optionally interconnected in a matrix, or pressed together have been observed to work well in the execution of the invention.

Advantageously, the reaction chamber assembly according to the invention allows to process at least two substrates at once.

The presence of at least two deposition units, each dedicated to one or more substrates, with all deposition units contained within one same enclosure, may provide for a particularly compact design.

According to an embodiment, the deposition unit **5** is provided with one receiving area **6** adapted to receive a substrate holder **7** designed to hold a single substrate.

Advantageously, the invention according to the present embodiment allows to deliver deposition quality comparable to a single-wafer reactor, with increased throughput.

According to an embodiment, the deposition unit **5** comprises a container; wherein said container optionally comprises a removable lid **16** releasably connected thereto.

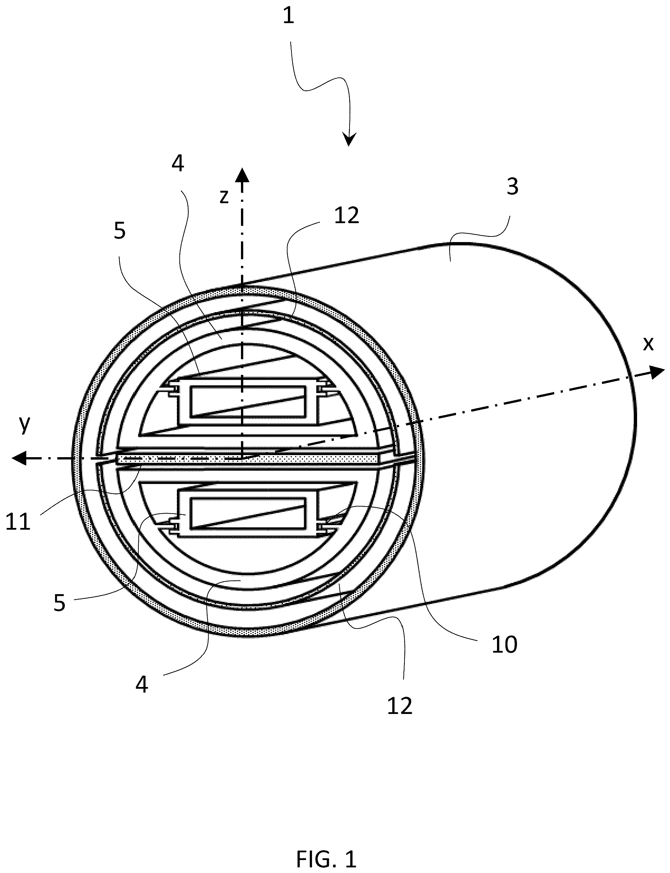

For example, the container, which defines the exterior of the deposition unit, may provide an essentially closed surface around the receiving area, except for a certain number of apertures. The apertures may be through-holes designed for the insertion and extraction of the substrate holder and/or for flowing and discharging gases. Additionally, they may be designed for monitoring systems or for inserting mechanical/automated systems. In a non-limiting example, the container may exhibit a box-like shape, as depicted in figures 1-6.

Advantageously, the container can provide a closed space of relatively small size, so all relevant parameters of the epitaxial deposition (such as temperature and pressure) can be easily controlled and kept uniform across the receiving area, thereby improving the quality of deposited films.

Advantageously, the removable lid allows to easily access the consumable parts surrounding the receiving area of the deposition unit for preventive maintenance operations. For ease of access, it may be a removable wall of the container, and can be placed opposite to the receiving area. The removable lid may be secured and released from the rest of the container via non-permanent mechanical interlocking or fastening mechanisms, such as hook and loop mechanisms, snap closures, or any other female-male fastening/joining means suitable to be quickly and easily secured and released.

According to an embodiment, each deposition unit **5** is mechanically connected to the casing **4** via releasable coupling means **10** and is moveable relative to the casing in one piece.

Advantageously, this embodiment allows to access the areas subject to parasitic deposition for cleaning in an easy manner, by simply removing the relatively small deposition unit from the reactor, manually or via automated means. In principle, the present design allows to perform this operation without exposing the deposition unit to air.

With great advantage, this design avoids having to displace the more cumbersome reaction chamber assembly and/or to have an operator enter within the reactor machine to access the concerned parts for preventive maintenance.

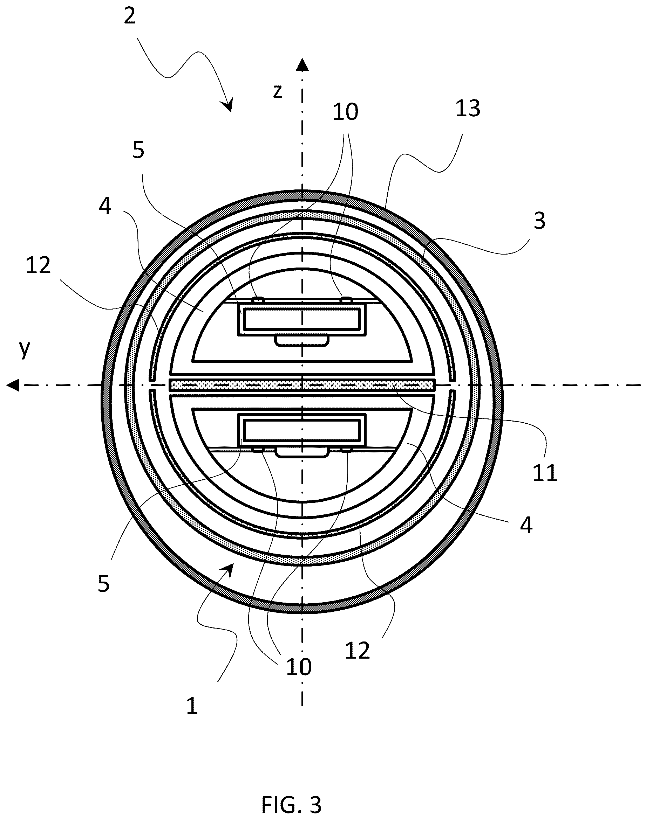

According to an embodiment, the releasable coupling means **10** are non-permanent mechanical interlocking, supporting, or fastening mechanisms. Non-limiting examples of releasable coupling means include grooves or protrusions formed on the deposition unit (in particular it's container) and/or the casing, and suitable to support, releasably fix, and/or direct the deposition unit on/into the casing. See for instance Fig.1 and Fig.3.

According to an embodiment, the deposition unit **5** comprises: (a) an inlet **8** suited to introduce a flow of gases in the deposition unit; and (b) an outlet **9** suited to discharge a flow of gases out of the deposition unit **5.**

The inlet **8** and the outlet **9** may comprise or consist of one or more apertures formed on the container of the deposition unit **5,** which respectively allow entrance of precursor, process, cleaning, and exhaust gases.

The inlet **8** may be connected, or releasably connected to a transition piece **15** positioned over an upstream aperture of the container and optionally adapted to be coupled with a precursor gas liner **17.**

The transition piece **15** may be optionally detachable, to ease the removal of the deposition unit **5.**

The outlet **9** may be also connected with a exhaust gas collecting element releasably or permanently attached to the downstream aperture, and optionally provided with a filter.

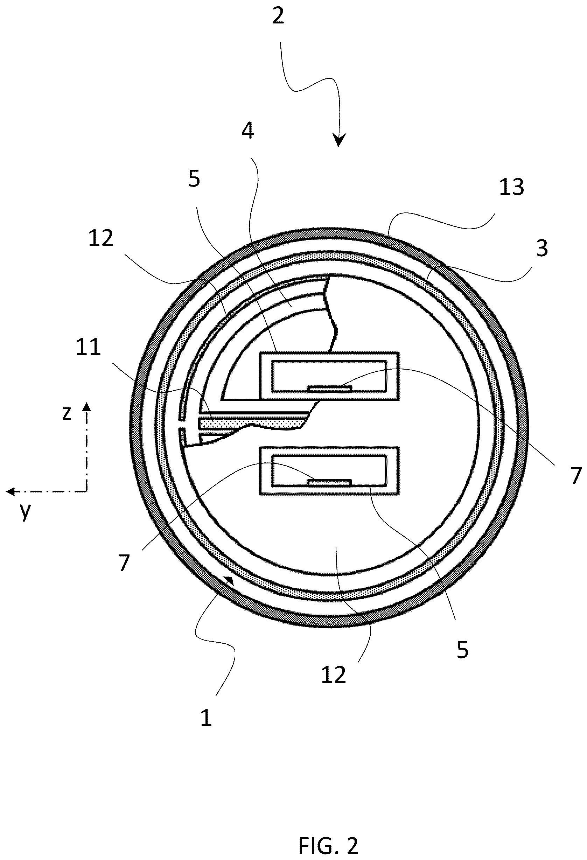

According to an embodiment, the insulating system comprises at least one insulating covering **12** adapted to cover in toto or in part at least one casing **4,** without detriment to the fact that it may cover both simultaneously. The insulating system may comprise at least three (or four) insulating coverings, and these may be movable with respect to each other. For instance, in case the reaction chamber assembly extends along a longitudinal direction (x), two insulating coverings may extend along the longitudinal direction (x), as depicted in Fig. 1, and two insulating coverings may be placed at opposite sides in the (yz) plane orthogonal to (x), as depicted in Fig. 2 (where only one insulating covering is shown).

Advantageously, this embodiment allows to thermally insulate the reaction chamber assembly from its surroundings, thereby increasing its heating efficiency and reducing operating costs.

For example, the insulating system or the insulating covering **12** can be made of porous carbonaceous materials.

For instance, carbon composites made from short cut carbon fibers, optionally interconnected in a matrix, or pressed together have been observed to work well in the execution of the invention.

According to an embodiment, the casing **4** is essentially hollow and extends along a longitudinal direction (x).

According to the present embodiment, the casing therefore features an internal surface and an external surface. The internal surface may be easily equipped with grooves or protrusions or stands adapted to engage with groves, protrusion, hooks, clasps, or fasteners of a deposition unit, to collectively perform as coupling means.

Advantageously, a hollow casing design is more lightweight, easier to handle than a bulk design, and may provide an improved heating profile to the disposition unit.

According to an embodiment, the casing **4** exhibits an essentially hollow prismatic, cylindrical or semicylindrical shape with a polygonal, circular, semicircular, oval, or elliptical cross-section in a transverse plane (yz) perpendicular to the longitudinal direction (x).

The inventors have observed that using two casings with a semicircular cross-section in the transverse plane (yz), where each casing is positioned with the flat side facing the other, provides for a conveniently compact design and may generate a desirable uniform heat profile within the deposition unit.

Examples of the above design are provided in Fig. 1, Fig. 2, Fig. 3 and Fig. 6.

According to an embodiment, the enclosure **3** is made of a non-susceptive material (i.e., substantially transparent or transparent to electromagnetic induction heating), such as quartz, and optionally cooled with a cooling fluid, such as water. For example, the enclosure **3** may be a double wall quartz tube, equipped with one or more cooling fluid inlets and outlets, to allow the fluid to flow in the interspace between the tubes.

Advantageously, a cooled, double wall quartz enclosure allows to effectively shield the surrounding environment from the heat generated by the reaction chamber assembly during operation. For instance, in silicon carbide reactors, the temperature inside the reaction chamber assembly may lie in the range of 1200-1700 ^{D}C, and it is therefore desirable to protect its environment from the effects of such temperatures. The use of quartz is particularly appreciated because it is transparent with respect to induction heating means and does not hinder visual inspection of the casings.

According to an embodiment, each casing **4** is made of a susceptive material suitable to be heated via an induction system **13.** Preferably, the susceptive material is graphite.

In the embodiments represented in figures 1-6, the reaction chamber assembly **1** comprises two essentially semicylindrical casings **4,** facing each other on their flat side. The enclosure **3** is an essentially cylindrical tube, enclosing the two casings **4.** This design is particularly compact, and advantageous in terms of heating, especially when the casing **4** is made of a susceptive material and the heating system is an induction system **13.**

According to an embodiment, the deposition unit **5** also comprises engaging means **14** adapted to couple with an end effector of an automated handling machine, in order to allow the deposition unit **5** to be automatically withdrawn/inserted from/into its casing **4** in one piece.

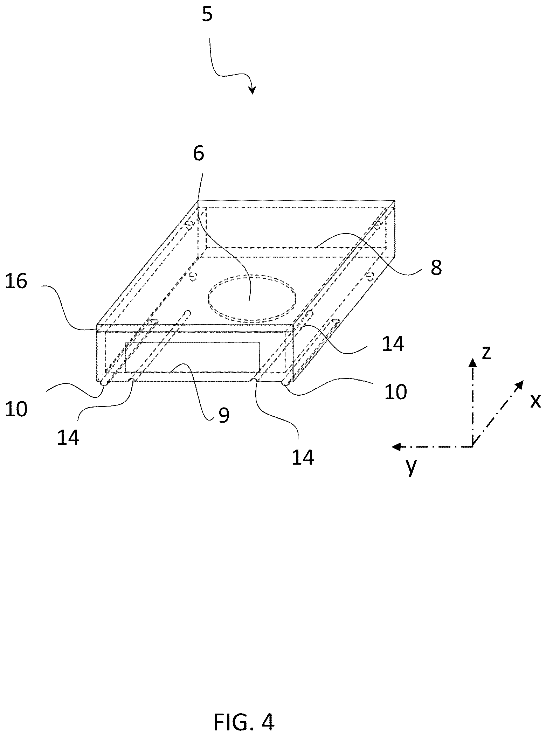

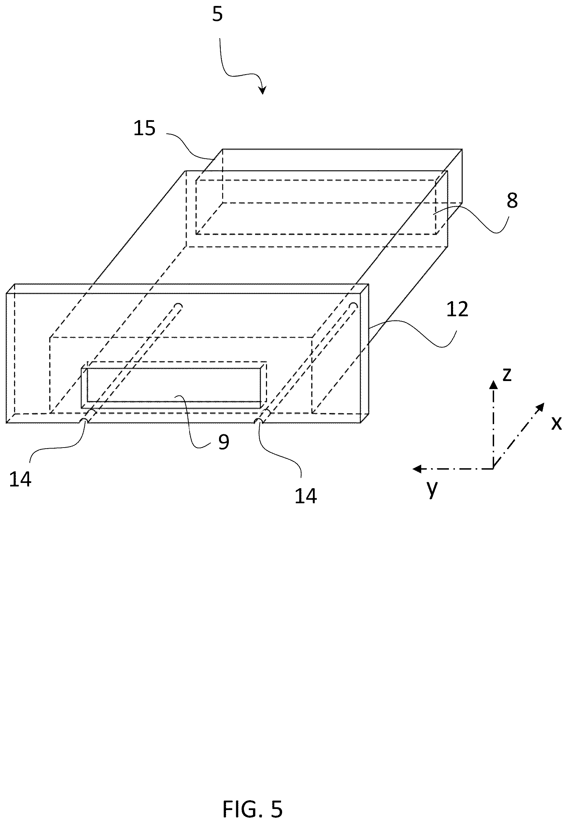

It is noted that the engaging means **14** may be groves or protrusions, as shown in Fig. 4 and Fig. 5, adapted to mechanically couple with an end effector, for example an end effector having an "Y-like" shape.

Advantageously, this embodiment allows to implement an automated solution for accessing the deposition unit for preventive maintenance operation, thereby simplifying and automating these operations.

According to a second aspect, the invention relates to a reactor **2** for the epitaxial deposition of a semiconductor film on at least two substrates.

The reactor comprises: (a) at least one reaction chamber assembly **1** according to any one of the embodiments hereinbefore described; (b) a heating system adapted to heat said at least two substrates; and (c) a gas line adapted to flow gas in and out of each deposition unit **5.**

Advantageously, the reactor according to the invention features a compact batch design, and may provide a "single-wafer"-like deposition environment, thus positively impacting on the quality of the treated substrates.

For example the reactor may advantageously comprise two or three reaction chamber assemblies to treat at least four or six substrates at a time.

According to an embodiment, the heating system of the reactor **2** is an induction system **13.**

For instance, in a non-limiting example, the induction system **13** comprises one or more solenoids, wrapped around the reaction chamber assembly, preferably around the enclosure **3** of the reaction chamber assembly **1,** as shown in Fig, 6.

According to an embodiment, the heating system is configured to heat the at least two substrates to a same and/or different temperature with respect to each other. This means that the heating system is configured to heat at a different temperature the receiving areas of two deposition units placed in different casings.

For instance, the heating system can be connected to a displacement mechanism. In this way, the heating system can be displaced relative to the reaction chamber assembly so that one deposition unit is subject to different heating conditions than another deposition unit.

In case of the induction system hereinbefore described and depicted in Fig.2, it can be displaced along the z direction relatively to said enclosure. To maximize this effect, it can be made asymmetric as the ovaloid shape depicted in Fig. 3. Alternatively, it can be made sufficiently larger than the enclosure to allow a sufficient displacement and to adapt the heating conditions to each deposition unit.

Advantageously, it is possible to adjust the flux coupled to the substrate holder to compensate a difference in temperature of the casings. This allows to have independently controlled deposition units.

To this effect, the induction system **13** may be advantageously connected to a servocontrol. The mean temperature may be used to control the total power, while the differences of the real temperatures in the deposition units are controlling the position of the coil.

According to an embodiment, the heating system comprises at least two independent heating elements. For example, two separate induction structures, curved or flat, may be used.

In this way, each heating element may independently control the temperature of a deposition unit. In this case the two induction elements may be fixed in space, but independently powered.

The present invention may be indifferently implemented in a horizontal or vertical reactor.

According to an embodiment, the reactor **2** is a horizontal crossflow reactor for the deposition of silicon carbide.

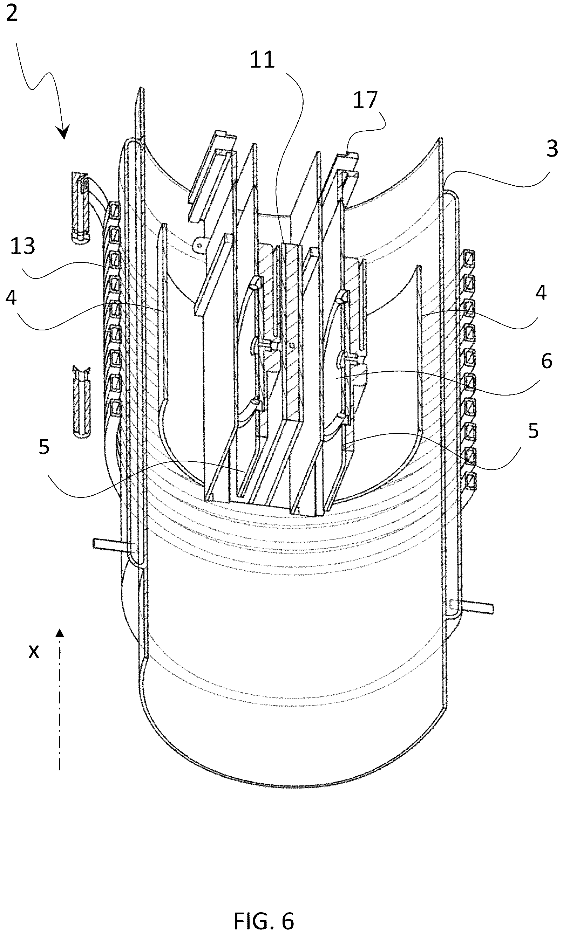

An example of the above embodiment is provided in Fig. 6.

It is understood that the reactor **2** according to any one of the above embodiments, may comprise many additional elements other than those explicitly listed herein, which the person with average skill in the art may recognize as desirable or implicitly included with the definition.

For example, the reactor **2** may comprise one or more pumps, one or more vacuum systems, one or more outer cabinets, one or more ports, one or more monitoring systems, one or more automated systems, and/or one or more security systems.

The subject matter of the present disclosure includes all novel and nonobvious combinations and sub-combinations of the various processes, systems, and configurations, and other features, functions, acts, and/or properties disclosed herein, as well as any and all equivalents thereof.

### LIST OF REFERENCES

1. Reaction chamber assembly
2. Reactor
3. Enclosure
4. Casing
5. Deposition unit
6. Receiving area
7. Substrate holder
8. Inlet
9. Outlet
10. Coupling means
11. Intermediate insulating element
12. Insulating covering
13. Induction system
14. Engaging means
15. Transition piece
16. Removable lid
17. Gas liner

## Claims

1. A reaction chamber assembly (1) for a reactor (2) for the epitaxial deposition of a semiconductor film on at least two substrates, comprising:
- an enclosure (3); and
- at least two casings (4) contained within said enclosure; and
- at least two deposition units (5); and
- an insulating system;
wherein each casing (4) contains at least one deposition unit (5); and
wherein each deposition unit (5) is provided with at least one receiving area (6) adapted to receive a substrate holder (7) and suitable for the epitaxial deposition of a semiconductor film on a substrate; and
wherein the insulating system comprises an intermediate insulating element (11) positioned between the at least two casings (4).

2. The reaction chamber assembly (1) according to claim 1, wherein each deposition unit (5) is provided with one receiving area (6) adapted to receive a substrate holder (7) for a single substrate.

3. The reaction chamber assembly (1) according to claim 1 or 2, wherein the deposition unit (5) comprises a container; wherein said container optionally comprises a removable lid (16) releasably connected thereto.

4. The reaction chamber assembly (1) according to any one of claims 1-3, wherein each deposition unit (5) is mechanically connected to the casing (4) via releasable coupling means (10) and is moveable relative to the casing in one piece.

5. The reaction chamber assembly (1) according to any one of claims 1-4, wherein the releasable coupling means (10) are non-permanent mechanical interlocking, supporting, and/or fastening mechanisms.

6. The reaction chamber assembly (1) according to any one of claims 1-5, wherein the deposition unit (5) comprises:
- an inlet (8) suited to introduce a flow of gases into the deposition unit; and
- an outlet (9) suited to discharge a flow of gases out of the deposition unit.

7. The reaction chambers assembly (1) according to any one of claims 1-6, wherein the insulating system comprises at least one insulating covering (12) adapted to cover in toto or in part at least one casing (4).

8. The reaction chamber assembly (1) according to any one of claims 1-7, wherein the casing (4) is essentially hollow and extends along a longitudinal direction (x).

9. The reaction chamber assembly (1) according to claim 8, wherein the casing (4) exhibits an essentially hollow prismatic, cylindrical or semicylindrical shape with a polygonal, circular, semicircular, oval, or elliptical cross-section in a transverse plane (yz) perpendicular to the longitudinal direction (x).

10. The reaction chamber assembly according to any one of claims 1-9, wherein the enclosure (3) is made of quartz.

11. The reaction chamber assembly (1) according to any one of claims 1-10, wherein each casing (4) is made of a susceptive material suitable to be heated via an induction system (13).

12. The reaction chamber assembly (1) according to any one of claims 1-11, wherein the deposition unit (5) further comprises engaging means (14) adapted to couple with an end effector of an automated handling machine in order to be automatically withdrawn/inserted from/into the casing (4) in one piece.

13. A reactor (2) for the epitaxial deposition of a semiconductor film on at least two substrates comprising:
- At least one reaction chamber assembly (1) according to any one of claims 1-12; and
- a heating system adapted to heat said at least two substrates; and
- a gas line adapted to flow gas in and out of each deposition unit (5).

14. The reactor (2) according to claim 13, wherein the heating system is an induction system (13).

15. The reactor (2) according to claim 13 or 14, wherein the heating system is configured to heat the at least two substrates to a same and/or different temperature with respect to each other.

16. The reactor (2) according to claim 15, wherein the heating system can be displaced relative to the at least two deposition units (5) and/or comprises at least two independent heating elements.

17. The reactor (2) according to any one of claims 13-16 wherein the reactor is a crossflow reactor for the deposition of silicon carbide.
